# EUROPEAN PATENT APPLICATION

(11) **EP 1 892 826 A1**
(43) Date of publication of application: **27.02.2008**
(21) Application number: 06756408.8
(22) Date of filing: 22.05.2006
(51) Int. Cl.: H03B 5/04, H03B 5/12

(54) **OSCILLATOR**

(30) Priority: 13.06.2005 JP 2005172796
(71) Applicant: KABUSHIKI KAISHA KOBE SEIKO SHO, Kobe-shi, Hyogo 651-8585 (JP)
(72) Inventor: KEGASA, Koyo, KABUSHIKI KAISHA KOBE SEIKO SHO, Nishi-ku, Kobe-shi, Hyogo 651-2271 (JP); MANABE, Chitaka, KABUSHIKI KAISHA KOBE SEIKO SHO, Nishi-ku, Kobe-shi, Hyogo 651-2271 (JP)
(74) Representative: Gillard, Richard Edward
(86) International application number: PCT/JP2006/310102
(87) International publication number: WO 2006/134750

(57) **Abstract**

An oscillator according to the present invention includes: an active element that oscillates at a predetermined frequency to output a signal of the predetermined frequency; and an impedance element having an impedance that is lower at a frequency lower than the predetermined frequency than at the predetermined frequency, the active element having signal terminals at least one of which is grounded through a series circuit composed of the impedance element and a capacitor.

## Description

### Technical Field

The present invention relates to an oscillator that oscillates at a predetermined frequency.

### Background Art

Fig. 4 is a circuit diagram of a configuration of an oscillator of the background art (see Patent Document 1, for example). An oscillator 101 of Fig. 4 is mainly used for a radio or the like. The oscillator 101 is composed of a resonator 102, a transistor 103, resistors 104, 105, and 106, and capacitors 107, 108, 109, 110, and 111. The transistor 103 has a collector connected to a power supply through the resistor 104, and also connected to a ground terminal through the capacitor 107 and is thus grounded at a high frequency.

A base of the transistor 103 is connected to the collector of the transistor 103 through the resistor 105. The transistor 103 has an emitter connected to the ground terminal through a parallel circuit composed of the resistor 106 and the capacitor 110. Further, the emitter and base of the transistor 103 are connected through the capacitor 109. Further, the base of the transistor 103 is connected to the resonator 102 through the capacitor 108.

This kind of circuit is called a Colpitts oscillating circuit, which oscillates at a resonance frequency of the resonator 102 to supply a frequency signal generated at the emitter of the transistor 103 to a load 112 through the capacitor 111.

For example, in the oscillator 101 configured to generate a frequency signal of, for example, a microwave band, the capacitors 107, 108, 109, 110, and 111 having a capacitance of about 0.1 pF to 0.1 µF are used.

Incidentally, an active element such as a transistor includes noise other than white noise and having an intensity that is substantially constant over a wide frequency range. The noise is called 1/f noise, and has an intensity that increases in inverse proportion to a frequency and becomes dominant at lower frequencies. It is generally known that in a low-noise bipolar transistor, the intensity of the 1/f noise is higher than that of the white noise and is dominant over the white noise at a low frequency of 10 kHz or less.

Further, in the above oscillator 101, the capacitors 107, 108, 109, 110, and 111 each have an impedance that is relatively low at an oscillation frequency of the oscillator 101 but is considerably high at a low frequency where the 1/f noise is dominant, for example, at a frequency of 10 kHz or less. Thus, all signal terminals of the transistor 103 are connected to relatively high impedance at the low frequency where the 1/f noise is dominant.

As a result, since the 1/f noise generated in the transistor 103 is confined to the transistor 103, the number of low-frequency noise components increase in a collector current of the transistor 103. Further, the oscillator 101 uses the transistor 103 in a nonlinear region, so low-frequency noise components around a DC component level are mixed with a signal of an oscillation frequency, and disadvantageously changed into phase noise around the oscillation frequency. Further, even in a circuit stabilized at a low frequency, if the oscillator 101 oscillates at a microwave-band frequency, parasitic oscillation might occur at a low frequency with a small amplitude due to a change in bias conditions accompanying a rectification behavior of the transistor 103 or the like.

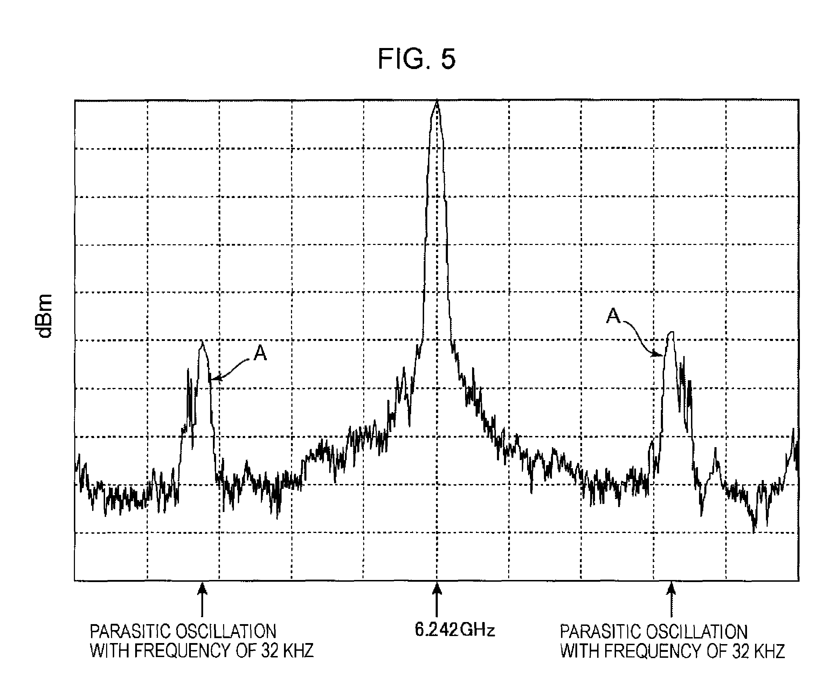

Fig. 5 shows a spectrum of an output signal of the oscillator 101 that involves parasitic oscillation. In Fig. 5, the horizontal axis represents frequency, and the vertical axis represents power. In Fig. 5, each of the squares along the horizontal axis corresponds to 10 kHz, and a range of 100 kHz is illustrated in total. In Fig. 5, each of the squares along the vertical axis corresponds to 10 dB, and a range of 100 dB is illustrated in total. The spectrum of Fig. 5 indicates a state in which parasitic oscillation occurs at a frequency of 32 kHz in the oscillator 101, an oscillation frequency of which is 6.242 GHz, and the parasitic oscillation is denoted by reference symbol A. Patent Document 1: Japanese Unexamined Patent Application Publication No. 2002-344240.

### Disclosure of Invention

The present invention has been accomplished in view of the above circumstances, and it is an object of the present invention to provide an oscillator that dissipates noise generated in an oscillating active element to the outside to reduce the noise or occurrences of parasitic oscillation.

An oscillator according to an aspect of the present invention includes: an active element that oscillates at a predetermined frequency to output a signal of the predetermined frequency; and an impedance element having an impedance that is lower at a frequency lower than the predetermined frequency than at the predetermined frequency, the active element having signal terminals at least one of which is grounded through a series circuit composed of the impedance element and a capacitor.

In the oscillator thus configured, the active element oscillates to output a signal of a predetermined frequency. Further, at least one of the signal terminals of the active element is grounded through a series circuit composed of a capacitor and an impedance element with impedance that is lower at a frequency lower than the predetermined frequency than at the predetermined frequency. Thus, the thus-configured oscillator can dissipate a low-frequency 1/f noise generated in the active element to the ground, with the result that occurrences of parasitic oscillation can be reduced and phase noise accompanying the 1/f noise can be reduced.

Here, the term the impedance that is lower at a frequency lower than the predetermined frequency than at the predetermined frequency means such characteristics that impedance is monotonously decreased from the predetermined frequency to a lower frequency in terms of frequency-impedance characteristics, or frequency characteristics of a coil or the like, which has an impedance decreased from the predetermined frequency to a lower frequency.

### Brief Description of the Drawings

Fig. 1 is a circuit diagram of a configuration example of an oscillator according to an embodiment of the present invention;
Fig. 2 is a graph of a spectrum of an oscillation signal output from the oscillator of Fig. 1;
Fig. 3 is a graph of phase noise of the oscillation signal output from the oscillator of Fig. 1;

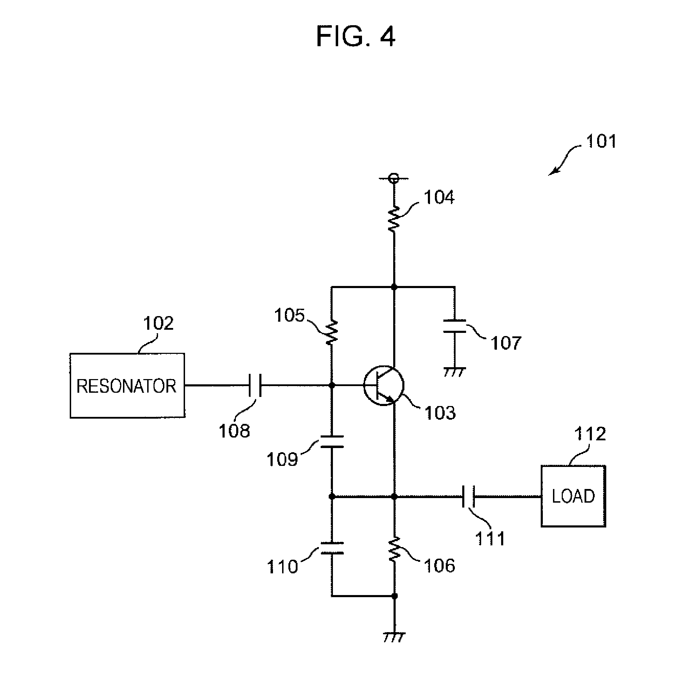

Fig. 4 is a circuit diagram of a configuration of an oscillator of the background art; and
Fig. 5 is a graph of a spectrum of an oscillation signal output from the oscillator of Fig. 4.

### Best Mode for Carrying Out the Invention

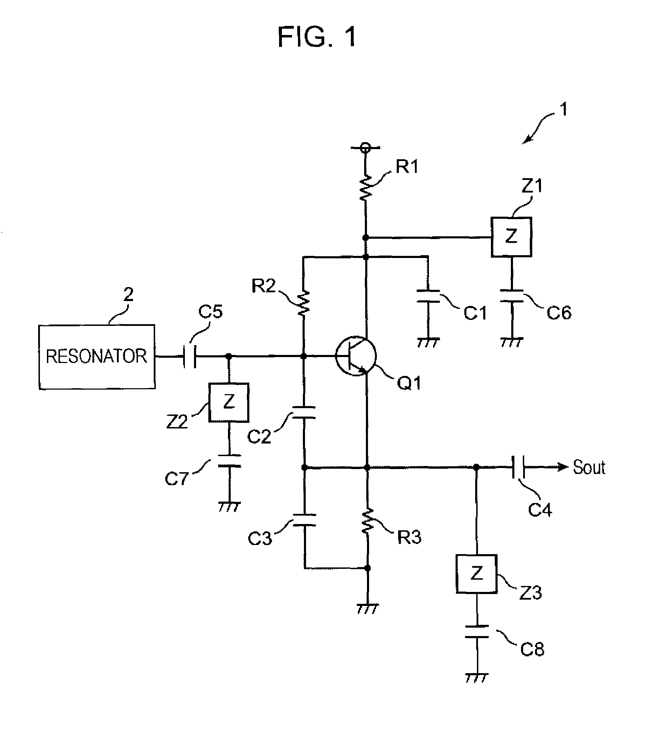

Hereinafter, embodiments of the present invention will be described with reference to the accompanying drawings. Incidentally, components having substantially the same functions are denoted by identical reference numerals throughout the drawings, and repeated description thereof is omitted. Fig. 1 is a circuit diagram of a configuration example of an oscillator according to an embodiment of the present invention. An oscillator 1 of Fig. 1 is a so-called Colpitts oscillating circuit. The oscillator is composed of a resonator 2, a transistor Q1 (active element), resistors R1, R2, and R3, capacitors C1, C2, C3, C4, C5, C6, C7, and C8, and impedance elements Z1, Z2, and Z3.

The transistor Q1 has a collector connected to a power supply through the resistor R1 and also to a ground terminal through the capacitor C1 and is thus grounded at a high frequency. A base terminal of the transistor Q1 is connected to the collector terminal of the transistor Q1 through the resistor R2. Further, an emitter terminal of the transistor Q1 is grounded through a parallel circuit composed of the resistor R3 and the capacitor C3. The emitter terminal and base terminal of the transistor Q1 are connected together through the capacitor C2. Then, the base terminal of the transistor Q1 is connected to the resonator 2 through the capacitor C5.

Further, the collector terminal of the transistor Q1 is grounded through a series circuit composed of the impedance element Z1 and the capacitor C6. The base terminal of the transistor Q1 is grounded through a series circuit composed of the impedance element Z2 and the capacitor C7. The emitter terminal of the transistor Q1 is grounded through a series circuit composed of the impedance element Z3 and the capacitor C8. In this way, in this embodiment, the collector terminal, the base terminal, and the emitter terminal of the transistor Q1 are grounded through the series circuit composed of the impedance element and the capacitor.

The transistor Q1 oscillates at a resonance frequency f of the resonator 2, and a frequency signal generated at the emitter terminal of the transistor Q1 is output to the outside as an oscillation signal Sout through the capacitor C4. In this case, the oscillation frequency of the oscillator 1 is also f.

As the resonator 2, for example, a quartz oscillator or an LC resonant circuit, or a dielectric resonator used for generating microwave resonance may be used.

The capacitors C1, C2, C3, C4, and C5 each have a capacitance of, for example, about 0.1 pF to 0.1 µF. Further, the capacitors C6, C7, and C8 each have a large capacitance of, for example, 10 µF or more.

The impedance elements Z1, Z2, and Z3 each have an impedance that is lower at a frequency lower than the oscillation frequency f than at the oscillation frequency f. The impedance of each of the impedance elements Z1, Z2, and Z3 is high, for example, 100 Ω or more at the oscillation frequency f. Further, the impedance of each of the impedance elements Z1, Z2, and Z3 is extremely low, for example, 5 Ω or less at a low frequency where 1/f noise is dominant, for example, a frequency of 10 kHz or lower.

Alternatively, the impedance of each of the impedance elements Z1, Z2, and Z3 is at least twice as high as a reference impedance of 50 Ω in a microwave circuit, at the oscillation frequency f. Further, the impedance of each of the impedance elements Z1, Z2, and Z3 may be set to 1/10 or less of the reference impedance at a low frequency where the 1/f noise is dominant.

The impedance elements Z1, Z2, and Z3 constitute a choke coil or a parallel resonance circuit composed of a coil and a capacitor. Alternatively, the impedance elements Z1, Z2, and Z3 may be a microstrip line having a length of λ/4 where λ represents a wavelength of a signal having the oscillation frequency f. In this case, if the parallel resonance circuit composed of a coil and a capacitor with a Q value of resonance of 30 or more or the microstrip line having a length of λ/4 is used as the impedance elements Z1, Z2, and Z3, the impedance elements Z1, Z2, and Z3 could each be easily made to have an impedance of 500 Ω or more at the oscillation frequency f.

Thus, since the impedance elements Z1, Z2, and Z3 each have an extremely high impedance, for example, 100 Ω or more at the oscillation frequency f, oscillating conditions of the oscillator 1 are not influenced thereby, and the oscillator 1 can oscillate at the oscillation frequency f.

On the other hand, the impedance elements Z1, Z2, and Z3 each have an extremely low impedance, for example, 5 Ω or less at a frequency where the 1/f noise is dominant, for example, at a low frequency of 10 kHz or less. Further, the capacitors C6, C7, and C8 series-connected to the impedance elements Z1, Z2, and Z3 each have a large capacitance. As a result, the impedance is very low even at a frequency where the 1/f noise is dominant. For example, if the capacitors C6, C7, and C8 each have a capacitance of 10 µF, impedance is 1.6 Ω at a frequency of 10 kHz where the 1/f noise is dominant.

Hence, the collector terminal, the base terminal, and the emitter terminal of the transistor Q1 are grounded through a low-impedance component in a frequency range where the 1/f noise is dominant. As a result, the 1/f noise of the transistor Q1 flows toward the ground from each signal terminal, so the level of 1/f noise components in a collector current of the transistor Q1 is considerably lowered. Then, as the level of 1/f noise components in the collector current is lowered, the proportion of 1/f noise being turned into phase noise is reduced, with the result that the phase noise is markedly reduced. Further, occurrences of parasitic oscillation at a low frequency of 1 kHz to 10 kHz are reduced because all of the terminals, the emitter, the base, and the collector, are grounded at low impedance.

As described above, the oscillating circuit of this embodiment dissipates the 1/f noise generated in the transistor Q1 that oscillates to the ground to thereby reduce noise or occurrences of parasitic oscillation.

In the present invention, it is desirable to set a capacitance of a capacitor constituting a series circuit together with an impedance element as follows. That is, assuming that phase noise is generated mainly in a frequency range of 300 Hz to 100 kHz, the capacitance is desirably set such that impedance of the capacitor is at least 50 Ω or less. For example, in the case of using a capacitor having an impedance of about 50 Ω at a frequency of 300 Hz, a capacitance of the capacitor is set to about 10 µF. Thus, according to the present invention, it is desirable to employ a capacitor having a capacitance of 10 µF or more.

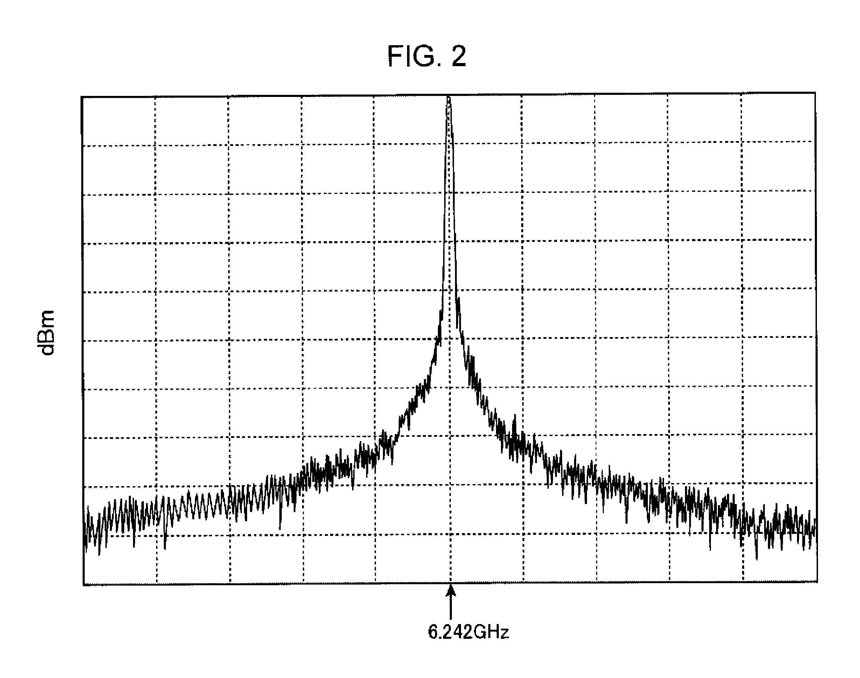

Fig. 2 is a graph of a spectrum of the oscillation signal Sout output from the oscillator 1 of Fig. 1. In Fig. 2, the horizontal axis represents frequency, and the vertical axis represents power. In Fig. 2, each of the squares along the horizontal axis corresponds to 10 kHz, and a range of 100 kHz is illustrated in total. In Fig. 2, each of the squares along the vertical axis corresponds to 10 dB, and a range of 100 dB is illustrated in total. As is apparent from Fig. 2, the spectrum of Fig. 2 does not involve parasitic oscillation of a conventional oscillator at a frequency of 32 kHz as denoted by reference symbol A of Fig. 5. As is also apparent from the spectrum of Fig. 2, phase noise is gradually lowered at both ends along the axis of oscillation frequency.

The elements Z1, Z2, and Z3 in the oscillator 1 each have frequency characteristics such that impedance is about 0 Ω at a DC level and then, gradually increases toward the oscillation frequency and reaches a peak value of about 1 kΩ at the oscillation frequency, and then decreases at a frequency higher than the oscillation frequency, after taking the data value as shown in Fig. 2. Such frequency characteristics can be realized with a parallel resonance circuit composed of a coil and a capacitor or a thin line.

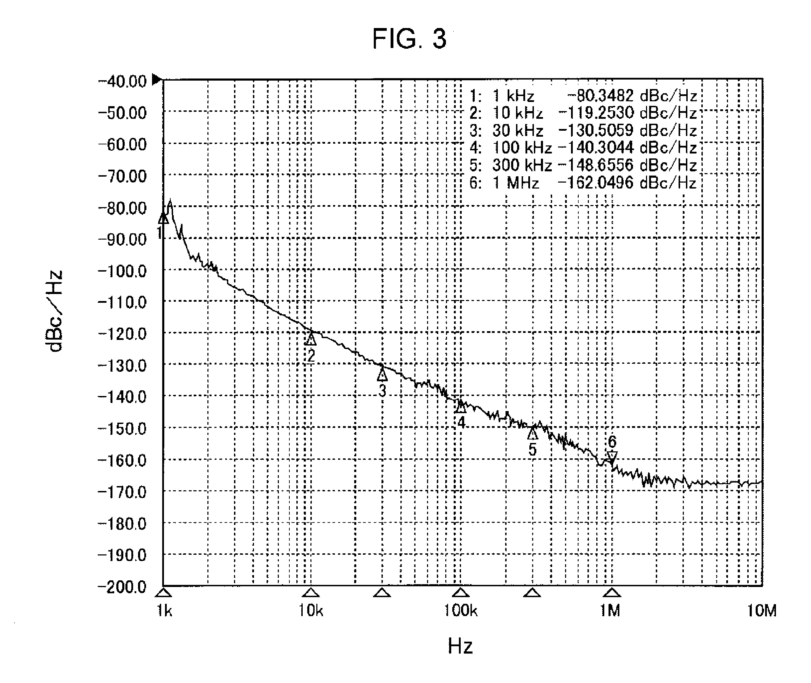

Fig. 3 is a graph of phase noise of the oscillation signal Sout under conditions such that the oscillation frequency f of the resonator 1 of Fig. 1 is 6.24 GHz, a dielectric resonator is used as the resonator 2, and the Q value of resonance is 1000. In Fig. 3, the horizontal axis represents an offset frequency that is offset from the oscillation frequency f, and the vertical axis represents noise power with respect to oscillation power in units of dB per Hz.

As shown in Fig. 3, in the oscillator 1 of Fig. 1 (with the same specifications as in the measurement result of Fig. 2), if the offset frequency is 10 kHz, the phase noise is - 119 dBc/Hz. If the offset frequency is 100 kHz, the phase noise is -140dBc/Hz. Thus, extremely low phase noise characteristics are obtained.

Further, the inventors of the subject application have measured phase noise of known microwave oscillators commercially available in Japan. The measurement result is as follows. That is, the measurement result shows that phase noise is -105 dBc/Hz at a frequency offset of 100 kHz in the US Hittite HMC358MS8G, phase noise is -110 dBc/Hz at a frequency offset of 100 kHz in the US Z-communications V965ME04, and phase noise is -110 dBc to -119 dBc/Hz at a frequency offset of 100 kHz in the Yokowo-Ube Giga Devices CDV307KS. It is confirmed that phase noise of the oscillator 1 of Fig. 1 is reduced as compared with the commercially available microwave oscillator.

As described above, in the oscillator 1 of Fig. 1, the signal terminals of the transistor Q1 that oscillates are grounded through a series circuit composed of an impedance element having an impedance that is lower in a frequency range where the 1/f noise is dominant than at an oscillation frequency, and a capacitor having low impedance, so the 1/f noise generated in the transistor Q1 can flow to the ground, making it possible to reduce occurrences of parasitic oscillation and phase noise resulting from the 1/f noise.

Incidentally, in the above example, the collector terminal, the base terminal, and the emitter terminal of the transistor Q1 are grounded through a series circuit composed of the impedance element Z1 and the capacitor C6, a series circuit composed of the impedance element Z2 and the capacitor C7, and a series circuit composed of the impedance element Z3 and the capacitor C8, respectively. However, in the oscillator 1, at least one of the base terminal, the collector terminal, and the emitter terminal of the transistor Q1 may be grounded through a corresponding one of the above series circuits.

Further, in the above example, the emitter of the transistor Q1 is grounded through a series circuit composed of the impedance element Z3 and the capacitor C8. However, in the oscillator 1, the emitter may be grounded only through the impedance element Z3 without using the capacitor C8.

Further, in the above example, the present invention is applied to the Colpitts oscillating circuit, but there is no limitation on a circuit type. As the oscillator of the present invention, it is possible to employ another type of oscillating circuit where at least one of the signal terminals of an active element that oscillates is grounded through a series circuit composed of an impedance element and a capacitor. The oscillator of the present invention is applicable to, for example, a negative resistance input oscillating circuit that oscillates by use of a parasitic capacitance of an element such as a transistor. In this case, the negative resistance input oscillating circuit used in a microwave band frequency, which can oscillate with a small capacitance.

Further, as the active element of the present invention, a vacuum tube, an Esaki diode, a Gunn diode, or the like is used.

Incidentally, the drawings and description used herein are given for illustrative purposes and are not construed as limiting the scope of the present invention.

An oscillator according to an embodiment of the present invention includes: an active element that oscillates at a predetermined frequency to output a signal of the predetermined frequency; and an impedance element having an impedance that is lower at a frequency lower than the predetermined frequency than at the predetermined frequency, the active element having signal terminals at least one of which is grounded through a series circuit composed of the impedance element and a capacitor.

In the thus-configured oscillator, the active element oscillates to thereby output a signal of a predetermined frequency. Further, at least one of the signal terminals of the active element is grounded through a series circuit composed of a capacitor and an impedance element having an impedance that is lower at a frequency lower than the predetermined frequency than at the predetermined frequency. Thus, the thus-configured oscillator can dissipate a low-frequency 1/f noise generated in the active element to the ground, with the result that occurrences of the parasitic oscillation can be reduced, and phase noise resulting from the 1/f noise can be reduced.

Further, in the above oscillator, the active element is a transistor, and a collector terminal of the transistor is grounded as the signal terminal through the series circuit.

In the thus-configured oscillator, the transistor oscillates to thereby output a signal of a predetermined frequency. Further, the collector terminal of the transistor is grounded through a series circuit composed of a capacitor and an impedance element having an impedance that is lower at a frequency lower than the predetermined frequency than at the predetermined frequency. Thus, the thus-configured oscillator can dissipate a low-frequency 1/f noise generated in the transistor to the ground, with the result that occurrences of the parasitic oscillation can be reduced, and phase noise resulting from the 1/f noise can be reduced.

Further, in the above oscillator, the active element is a transistor, and a base terminal of the transistor is grounded as the signal terminal through the series circuit.

In the thus-configured oscillator, the transistor oscillates to thereby output a signal of a predetermined frequency. Further, the base terminal of the transistor is grounded through a series circuit composed of a capacitor and an impedance element having an impedance that is lower at a frequency lower than the predetermined frequency than at the predetermined frequency. Thus, the thus-configured oscillator can dissipate a low-frequency 1/f noise generated in the transistor to the ground, with the result that occurrences of the parasitic oscillation can be reduced, and phase noise resulting from the 1/f noise can be reduced.

Further, in the above oscillator, the active element is a transistor, and an emitter terminal of the transistor is grounded as the signal terminal through the series circuit.

In the thus-configured oscillator, the transistor oscillates to thereby output a signal of a predetermined frequency. Further, the emitter terminal of the transistor is grounded through a series circuit composed of a capacitor and an impedance element having an impedance that is lower at a frequency lower than the predetermined frequency than at the predetermined frequency. Thus, the thus-configured oscillator can dissipate a low-frequency 1/f noise generated in the transistor to the ground, with the result that occurrences of the parasitic oscillation can be reduced, and phase noise resulting from the 1/f noise can be reduced.

Further, in the above oscillator, the emitter terminal is grounded through the impedance element in place of the series circuit.

The thus-configured oscillator can dissipate a low-frequency 1/f noise generated in the transistor to the ground from the emitter terminal through the impedance element in place of the series circuit, so a circuit can be simplified by reducing the number of capacitors in the series circuit.

## Claims

1. An oscillator comprising:
an active element that oscillates at a predetermined frequency to output a signal of the predetermined frequency; and
an impedance element having an impedance that is lower at a frequency lower than the predetermined frequency than at the predetermined frequency,
the active element having signal terminals at least one of which is grounded through a series circuit composed of the impedance element and a capacitor.

2. The oscillator according to claim 1, wherein the active element is a transistor, and a collector terminal of the transistor is grounded as the signal terminal through the series circuit.

3. The oscillator according to claim 1, wherein the active element is a transistor, and a base terminal of the transistor is grounded as the signal terminal through the series circuit.

4. The oscillator according to claim 1, wherein the active element is a transistor, and an emitter terminal of the transistor is grounded as the signal terminal through the series circuit.

5. The oscillator according to claim 4, wherein the emitter terminal is grounded through the impedance element in place of the series circuit.
